Europäisches Patentamt

European Patent Office

Office européen des brevets

(19)

(11) **EP 0 953 398 A1**

(12) **EUROPÄISCHE PATENTANMELDUNG**

(43) Veröffentlichungstag:
**03.11.1999 Patentblatt 1999/44**

(51) Int. Cl.$^6$: **B23K 20/00**

(21) Anmeldenummer: 98810104.4

(22) Anmeldetag: 06.02.1998

(84) Benannte Vertragsstaaten:
**AT BE CH DE DK ES FI FR GB GR IE IT LI LU MC
NL PT SE**
Benannte Erstreckungsstaaten:
**AL LT LV MK RO SI**

(71) Anmelder: **ESEC SA
CH-6330 Cham (CH)**

(72) Erfinder:
• **Bolliger, Daniel
6003 Luzern (CH)**
• **Mayer, Michael
8037 Zürich (CH)**
• **Paul, Oliver
79280 Au (DE)**
• **Stössel, Zeno 43
6312 Steinhausen (CH)**

(54) **Verfahren und Chip für die Kalibrierung eines Wire Bonders**

(57) Für die Kalibrierung der Parameter eines Wire Bonders (3) wird ein Testchip (2) mit Sensoren (5; 6) eingesetzt, die entweder unterhalb eines Anschlusspunktes (4) (Bondpads) oder seitlich versetzt neben dem Anschlusspunkt (4) im Testchip (2) integriert sind. Der zeitliche Verlauf der Signale der vorzugsweise als Widerstandselemente ausgebildeten Sensoren (5; 6) wird in-situ während des Bondens auf den Anschlus-spunkt (4) erfasst, von einer Auswerteelektronik verarbeitet und benutzt für die Kalibrierung des Wire Bonders. Mit solchen Sensoren (5; 6) lassen sich insbesondere die Bondkraft sowie die Leistung und die Zeitdauer der beim Bonden zugeführten Ultraschallenergie kalibrieren.

Fig 1

EP 0 953 398 A1

## Beschreibung

Die Erfindung betrifft ein Verfahren und einen Chip für die Kalibrierung eines Wire Bonders.

Einen Wire Bonder kalibrieren heisst, verschiedene Parameter des Wire Bonders, die den Bondprozess beeinflussen, wie z.B. die Bondkraft, die Leistung und die Zeitdauer der beim Bonden zugeführten Ultraschallenergie, die Temperatur, auf die das Substrat aufgeheizt wird, das den zu bondenden Halbleiterchip trägt, usw. optimal und reproduzierbar einzustellen.

Der Erfindung liegt die Aufgabe zugrunde, ein Verfahren und Mittel anzugeben, mit deren Hilfe ein Wire Bonder auf einfache Weise kalibrierbar ist.

Die genannte Aufgabe wird erfindungsgemäss gelöst durch die Merkmale der Ansprüche 1 und 5.

Gemäss der Erfindung wird die Aufgabe dadurch gelöst, dass ein Testchip bereitgestellt wird, der vorzugsweise mehrere Anschlusspunkte, sogenannte Bondpads, aufweist, denen mindestens ein Sensor zugeordnet ist. Diese Sensoren sind entweder unterhalb des Anschlusspunktes oder seitlich versetzt neben dem Anschlusspunkt im Testchip integriert. Der zeitliche Verlauf der Signale der vorzugsweise als Widerstandselemente ausgebildeten Sensoren wird in-situ während des Bondens auf den Anschlusspunkt oder während eines für die Kalibrierung der Parameter des Wire Bonders geeigneten Prozesses erfasst, von einer Auswerteelektronik verarbeitet und benutzt für die Kalibrierung des Wire Bonders. Mit solchen Sensoren lassen sich insbesondere die Bondkraft sowie die Leistung und die Zeitdauer der beim Bonden zugeführten Ultraschallenergie kalibrieren.

Nachfolgend werden Ausführungsbeispiele der Erfindung anhand der Zeichnung näher erläutert. Es zeigen:

Fig. 1        Teile eines Wire Bonders und einen Testchip in Seitenansicht,

Fig. 2a, b   einen im Testchip integrierten druckempfindlichen Sensor,

Fig. 3        eine Widerstandskennlinie,

Fig. 4        einen weiteren druckempfindlichen Sensor,

Fig. 5        den zeitlichen Verlauf des vom druckempfindlichen Sensor gelieferten Signals, das proportional zur Bondkraft ist,

Fig. 6a, b   einen temperaturempfindlichen Sensor,

Fig. 7        den vom temperaturempfindlichen Sensor gemessenen Temperaturverlauf bei einem Bondprozess, bei dem keine Verschweissung erfolgt,

Fig. 8        den vom temperaturempfindlichen Sensor gemessenen Temperaturverlauf bei einem normalen Bondprozess, und

Fig. 9        eine Anordnung mit als Widerstandsbrücke geschalteten Sensoren.

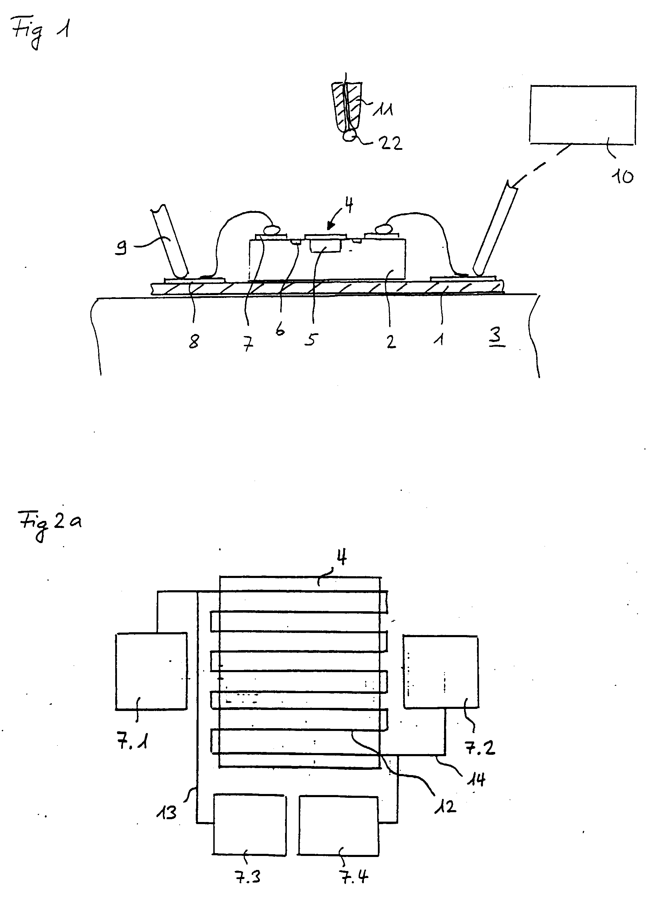

Die Fig. 1 zeigt in Seitenansicht einen auf einem Substrat 1 montierten Testchip 2, der der Bondstelle eines Wire Bonders 3 zugeführt ist. Der Testchip 2 weist auf seiner Oberfläche einen ersten Anschlusspunkt 4 auf. Unterhalb des ersten Anschlusspunktes 4 ist ein erster Sensor 5 im Testchip 2 integriert. Seitlich versetzt neben dem ersten Anschlusspunkt 4 ist ein zweiter Sensor 6 im Testchip 2 integriert. Die Sensoren 5, 6 dienen dazu, den Bondvorgang auf den ersten Anschlusspunkt 4 in-situ zu verfolgen. Die Sensoren 5, 6 sind mit zweiten Anschlusspunkten 7 verbunden. Das Substrat 1 ist beispielsweise aus Kunststoff gefertigt und weist dritte Anschlusspunkte 8 auf. Das Substrat 1 kann standardmässig der Bondstelle des Wire Bonders 3 zugeführt werden.

Das Bonden der Drahtverbindungen zwischen den zweiten Anschlusspunkten 7 auf dem Testchip 2 und den dritten Anschlusspunkten 8 auf dem Substrat 1 erfolgt mittels einer Kapillare 11. Diese Drahtverbindungen werden vorgängig in einem separaten Bondprozess angebracht, falls wenigstens einer der Sensoren 5, 6 geeicht werden muss, bevor er für die Kalibrierung des Wire Bonders 3 verwendet werden kann. Falls keiner der Sensoren 5, 6 geeicht werden muss, können die Verbindungen zwischen den zweiten und den dritten Anschlusspunkten 7 bzw. 8 vom Wire Bonder 3 selbsttätig unmittelbar vor der Kalibrierung gebondet werden. Der Wire Bonder 3 enthält zudem Nadeln 9 zur Kontaktierung der Anschlusspunkte 8 des Substrates 1, so dass die von den Sensoren 5, 6 gelieferten elektrischen Signale einer Auswerteelektronik 10 zugeleitet werden können. Sobald der Testchip 2 der Bondstelle zugeführt ist, werden die Nadeln 9 soweit abgesenkt, dass sie die dritten Anschlusspunkte 8 kontaktieren.

Die Fig. 2a und 2b zeigen in der Draufsicht und in Seitenansicht den unterhalb des ersten Anschlusspunktes 4 angeordneten ersten Sensor 5. Der Testchip 2 besteht in diesem Beispiel aus p-dotiertem Silizium. Eine in das p-dotierte Silizium diffundierte mäanderförmige $n^+$-Bahn 12 bildet den ersten Sensor 5. Der Sensor 5 wird als Widerstandselement betrieben. Die $n^+$-Bahn 12 verbindet daher zwei zweite Anschlusspunkte 7.1 und 7.2, so dass ein von einer externen Quelle eingespeister Strom vom Anschlusspunkt 7.1 zum Anschlusspunkt 7.2 fliessen kann. Die $n^+$-Bahn 12 ist an ihrem einen Ende mit einer zweiten $n^+$-Bahn 13 und an ihrem anderen Ende mit einer dritten $n^+$-Bahn 14 verbunden, die zu zweiten Anschlusspunkten 7.3 und 7.4 führen, so dass mit einer Vier-Punktsmessung der elektrische Widerstand der $n^+$-Bahn 12 gemessen werden kann. Der Testchip 2 ist in herkömmlicher Weise, beispielsweise gemäss einem Bipolar Prozess oder einem CMOS Prozess, hergestellt, d.h. die Oberfläche des Bulksiliziums oberhalb der $n^+$-Bahn 12 ist von einer Oxidschicht 15, einer die Anschlusspunkte 4 und 7 bildenden Metallschicht 16 und einer Passivierungsschicht 17 bedeckt.

Der Sensor 5 eignet sich zur in-situ Messung der Kraft $F_B$, der sogenannten Bondkraft, die die Spitze der den Bonddraht führenden Kapillare 11 (Fig. 1) während des Bondvorganges auf den ersten Anschlusspunkt 4 ausübt. Der elektrische Widerstand der $n^+$-Bahn 12 hängt jedoch nicht nur von der Bondkraft $F_B$ ab, sondern auch von der beim Anschlusspunkt 4 des Testchips 2 herrschenden Temperatur T.

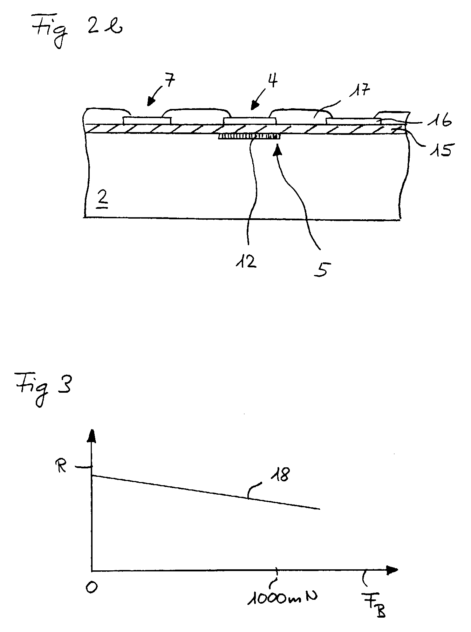

Die Fig. 3 zeigt die Beziehung zwischen dem elektrischen Widerstand R der $n^+$-Bahn 12 und der Bondkraft $F_B$ bei Zimmertemperatur, die im wesentlichen eine Gerade 18 mit der Steigung $\alpha$ ist. Die Bestimmung der Bondkraft $F_B$ erfolgt nun bei Zimmertemperatur gemäss den folgenden Schritten:

a) Messung des elektrischen Widerstandes $R_1$ des Sensors 5, ohne dass die Kapillare 11 (Fig. 1) den Anschlusspunkt 4 berührt.
b) Messung des elektrischen Widerstandes $R_2$ des Sensors 5, wobei die Kapillare 11 den Anschlusspunkt 4 mit einer Soll-Bondkraft $F_{B,soll}$ beaufschlagt.
c) Bestimmung der Ist-Bondkraft $F_{B,ist}$ gemäss der Gleichung

$$F_{B,ist} = \frac{R_2 - R_1}{\alpha} \qquad (1).$$

Die Widerstandswerte $R_1$ und $R_2$ sind also zu messende Werte, während die Steigung $\alpha$ entweder bei einer vorhergehenden Eichung des Testchips 2 bestimmt wurde oder als universelle Konstante verfügbar ist. Der Wire Bonder lässt sich nun kalibrieren, indem der Parameter, der die Bondkraft $F_B$ steuert, soweit verändert wird, bis die gemessene Ist-Bondkraft $F_{B,ist}$ gleich der Soll-Bondkraft $F_{B,soll}$ ist.

Das Bonden von Drahtverbindungen erfolgt normalerweise bei Temperaturen, die wesentlich höher als die Zimmertemperatur sind. Das Substrat 1 liegt deshalb auf einer Heizplatte des Wire Bonders 3 auf, deren Temperatur geregelt ist. Sobald die Kapillare 11 auf den zu bondenden Anschlusspunkt 4 aufsetzt, wird jedoch Wärme abgeführt, was dazu führt, dass die Temperatur des Anschlusspunktes 4 und des darunter integrierten Sensors 5 sinkt. Da der Widerstand der $n^+$-Bahn 12 (Fig. 2) temperaturabhängig ist, erfolgt die Kalibrierung der Bondkraft $F_B$ mit dem vorgängig beschriebenen Verfahren vorteilhaft bei Zimmertemperatur, bei der keine Abkühlung stattfindet.

Da sich beim Bonden bei erhöhter Temperatur auch die Umgebung und damit auch der Bondkopf erwärmt, ist es unter Umständen jedoch vorteilhaft, die Kalibrierung der Bondkraft $F_B$ bei dieser erhöhten Temperatur durchzuführen. Bei Temperaturen oberhalb etwa 150°C fliessen beim Sensor 5 relativ hohe Leckströme zwischen der $n^+$-Bahn 12 und dem p-dotierten Bulksilizium, was die Genauigkeit des Sensors 5 beeinträchtigt. Bei Temperaturen oberhalb etwa 150°C wird deshalb bevorzugt ein anderer Sensor 5' für die Kalibrierung der Bondkraft $F_B$ verwendet.

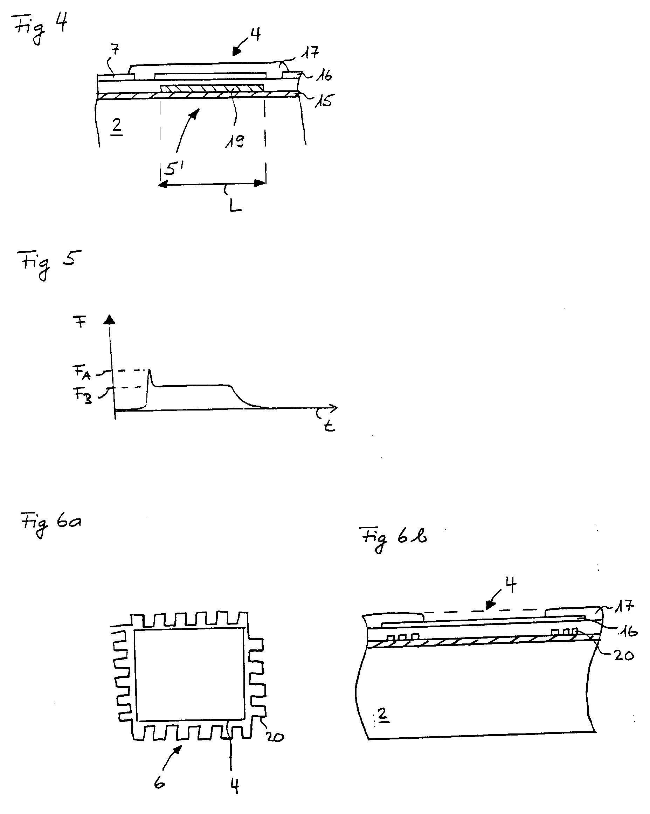

Die Fig. 4 zeigt den Sensor 5', bei dem die in das Bulksilizium diffundierte $n^+$-Bahn 12 des vorgängig beschriebenen Sensors 5 ersetzt ist durch eine mäanderförmige Bahn aus n-dotiertem Polysilizium 19, das auf der Oxidschicht 15 abgeschieden wurde. Für die Messung der Bondkraft $F_B$ ist es ohne Bedeutung, ob die Metallschicht 16 beim Anschlusspunkt 4 vorhanden ist oder nicht und ob sie mit der Passivierungsschicht 17 bedeckt ist oder nicht. In der Fig. 4 ist der Fall dargestellt, dass die Metallschicht 16 beim Anschlusspunkt 4 vorhanden ist und dass die Passivierungsschicht 17 den Anschlusspunkt 4 vollständig bedeckt.

Die Kalibrierung erfolgt wiederum gemäss den oben beschriebenen Schritten a - c, wobei jedoch in die Gleichung (1) ein von der Temperatur T abhängiger Wert für die Steigung $\alpha$ einzusetzen ist. Die Abhängigkeit der Steigung $\alpha(T)$ wird bei der Eichung des Sensors 5' bestimmt. Die Temperatur T kann entweder dem Temperatursensor entnommen werden, der zur Regelung der Temperatur der Heizplatte dient, oder sie kann mit dem zweiten Sensor 6 direkt gemessen werden, sofern dieser ein temperaturempfindlicher Sensor ist.

Die linearen Abmessungen L der $n^+$-Bahn 12 des Sensors 5 bzw. der mäanderförmigen Bahn des Polysiliziums beim Sensor 5' sind so gross gewählt, dass einerseits Verschiebungen des Ortes, an dem die Bondkugel 22 bzw. die Spitze der Kapillare 11 den Anschlusspunkt 4 berührt, die innerhalb der Positionierungsgenauigkeit der Kapillare 11 liegen, keinen Einfluss auf den Messwert des Sensors haben und dass andererseits das Nutzsignal möglichst gross ist.

Die Sensoren 5 und 5' ermöglichen nicht nur die einfache Kalibrierung des statischen Wertes der Bondkraft $F_B$, sondern sie ermöglichen auch eine Analyse der auf den Anschlusspunkt 4 ausgeübten Bondkraft F in Funktion der Zeit t. Aus dem in der Fig. 5 dargestellten Verlauf der Bondkraft F ist ersichtlich, dass die Kapillare 11 beim Aufprall eine Aufprallkraft $F_A$ auf den Anschlusspunkt 4 ausübt, die z.B. doppelt so gross ist wie die gewünschte Ist-Bondkraft $F_{B,ist}$. Die Stärke der Aufprallkraft $F_A$ ist entscheidend für die Vorverformung der Bondkugel 22. Mit dieser Messung kann nun die Stärke der Kraft $F_A$ bestimmt und kalibriert werden, damit die auf verschiedenen Wire Bondern 3 hergestellten Bondkugeln nach dem Aufprall der Kapillare 11 auf dem Bondpad alle die gleiche Form aufweisen. Die Stärke der Kraft $F_A$ kann dabei durch die Steuerung der Geschwindigkeit der Kapillare 11 unmittelbar vor deren Aufprall gezielt optimiert werden.

Die Fig. 6a und 6b zeigen einen temperaturempfindlichen Sensor 6, der zur Kalibrierung der Ultraschallenergie vorgesehen ist, die beim Bonden zugeführt wird. Damit der Sensor 6 beim Bonden nicht beschädigt wird und damit sich dem Sensorsignal nicht durch Stresseffekte bedingte Signale überlagern, ist er neben dem Anschlusspunkt 4 angeordnet. Der Sensor 6 ist gebildet durch Leiterbahnen 20 aus Aluminium. Damit die beim Ultraschallschweissen zugeführte Wärme möglichst gut zum Sensor 6 geleitet wird, ist die den Anschlusspunkt 4 bildende zweite Metallschicht 16 seitlich über den Sensor 6 hinaus geführt.

Bei einer ersten Ausführung des Sensors 6 bedeckt die Passivierungsschicht 17 den Anschlusspunkt 4 vollständig (gestrichelte Linie). Dies hat zur Folge, dass die Kapillare 11 zwar Ultraschallenergie auf den Anschlusspunkt 4 übertragen kann, ein Ultraschallschweissen des Bonddrahtes auf der Passivierungsschicht 17 findet jedoch nicht statt. D.h. die Bondkugel (engl. ball) des Bonddrahtes haftet nicht auf der Passivierungsschicht 17.

Die Kalibrierung der Ultraschallenergie erfolgt gemäss den folgenden Schritten:

a) Aufsetzen der Kapillare 11 auf dem Anschlusspunkt 4 mit einer vorbestimmten Bondkraft $F_B$.
b) Warten, bis das vom Sensor 6 gelieferte Signal einen konstanten Wert anzeigt. Dies bedeutet, dass nach anfänglicher, rascher Abkühlung, die nur einige Millisekunden dauert, die Temperatur des Anschlusspunktes 4 wieder einen stabilen Wert erreicht hat.
c) Einschalten des die Kapillare 11 beaufschlagenden Ultraschallwandlers mit einer vorbestimmten Leistung.
d) Erfassen der durch die Zufuhr von Ultraschallenergie bedingten Temperaturerhöhung $\Delta T$ durch den Sensor 6.
e) Verändern der zugeführten Ultraschallleistung, bis die durch die zugeführte Ultraschallenergie bedingte Temperaturerhöhung $\Delta T$ gleich einem vorbestimmten Wert $\Delta T_1$ ist.

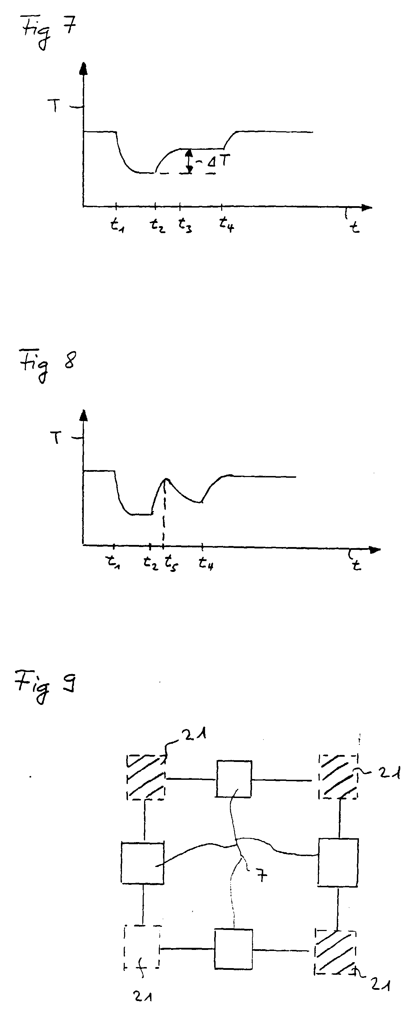

Die Fig. 7 zeigt den zeitlichen Verlauf der vom Sensor 6 gemessenen Temperatur. Zum Zeitpunkt $t_1$ setzt die Kapillare 11 auf dem Anschlusspunkt 4 auf, was dazu führt, dass sich der Anschlusspunkt 4 abkühlt. Nach einigen Millisekunden hat der Anschlusspunkt 4 das thermische Gleichgewicht wieder erreicht, so dass zum Zeitpunkt $t_2$ die Kapillare 11 mit Ultraschall beaufschlagt werden kann. Infolge der Übertragung von Energie von der Kapillare 11 auf den Anschlusspunkt 4 erhöht sich die Temperatur T des Anschlusspunktes 4 um den Wert $\Delta T$ und erreicht ein stabiles Gleichgewicht. Zum Zeitpunkt $t_4$ wird die Zufuhr von Ultraschallenergie gestoppt.

Da die Bondkugel auf der Passivierungsschicht 17 nicht haftet, kann dieses Kalibrierungsverfahren problemlos bei mehreren vorgegebenen Werten der Ultraschallleistung $P_{US}$ durchgeführt werden. So ist es also möglich, den Wire Bonder 3 so zu kalibrieren, dass die vom Sensor 6 gemessene Temperaturerhöhung $\Delta T(P_{US})$ in Abhängigkeit der eingestellten Ultraschallleistung $P_{US}$ einer vorgegebenen Kennlinie folgt.

Bei einer zweiten Ausführung des Sensors 6'

bedeckt die Passivierungsschicht 17 den Anschlusspunkt 4 nicht. Dies hat zur Folge, dass die Bondkugel mit dem metallischen Anschlusspunkt 4 verschweisst wird. Die Fig. 8 zeigt nun den zeitlichen Verlauf der vom Sensor 6' gemessenen Temperatur T. Wie aus dem Diagramm ersichtlich ist, erhöht sich die vom Sensor 6' gemessene Temperatur T ab dem Zeitpunkt $t_2$, an dem dem Anschlusspunkt 4 Ultraschallenergie zugeführt wird, sehr schnell, erreicht zum Zeitpunkt $t_5$ ein Maximum und nimmt dann wieder ab. Beim Zeitpunkt $t_4$ hebt die Kapillare 11 wieder ab. Sobald die Bondkugel mit dem Anschlusspunkt 4 verschweisst, gibt es keine Relativbewegung und damit auch keine Reibung mehr zwischen der Bondkugel und dem Anschlusspunkt 4, weshalb die Temperatur wieder abnimmt. D.h. dass zum Zeitpunkt $t_5$ die Bondverbindung zwischen der Bondkugel und dem Anschlusspunkt 4 hergestellt ist. Als eigentliche Bondzeit, die zum Schweissen der Bondkugel benötigt wird, ergibt sich somit die Zeitdauer $\Delta t = t_5 - t_2$. Mit dem Sensor 6' ist es somit möglich, die Bondzeit direkt zu messen und den Wire Bonder 3 optimal so einzustellen, dass die effektiv eingestellte Bondzeit $\Delta t_{eff}$ nur um eine Sicherheitszeitspanne länger als die Zeitdauer $\Delta t$ ist.

Die Fig. 9 zeigt eine Anordnung, bei der vier Sensoren 21, die als Widerstandselemente betrieben sind, als Widerstandsbrücke (Wheatstone) geschaltet sind. Die Widerstandsbrücke weist vier zweite Anschlusspunkte 7 auf, von denen zwei zur Einspeisung des Messstromes und von denen die beiden anderen zur Messung der Spannung der Widerstandsbrücke dienen. Als Sensoren sind z.B. die vorgängig beschriebenen Sensoren 5, 5', 6 oder 6' eingesetzt. In der Figur sind drei Sensoren 21 schraffiert und ein Sensor 21 ohne Schraffur dargestellt. Dies bedeutet hier, dass der Anschlusspunkt 4 bei den schraffierten Sensoren 21 eine metallene Oberfläche aufweist, so dass ein normaler Bondprozess durchgeführt werden kann, während beim Sensor 21 ohne Schraffur die Passivierungsschicht den Anschlusspunkt 4 vollständig bedeckt, so dass kein Schweissvorgang stattfinden kann.

Die Verwendung solcher Mikrosensoren, die direkt bei den Bondpads angeordnet sind, erlaubt es, die den Bondprozess beeinflussenden physikalischen Grössen genauer als mit herkömmlichen Sensoren zu messen und zu analysieren. Bei sorgfältigem Design der Mikrosensoren lassen sich zudem eindeutige Rückschlüsse vom Sensorsignal auf die Einstellparameter ziehen. Zwischen den verschiedenen Parametern wie z.B. Bondkraft und Ultraschallleistung besteht natürlich eine Korrelation. Das heisst beispielsweise, dass die zugeführte und vom Mikrosensor gemessene Ultraschallleistung davon abhängt, mit welcher Bondkraft die Kapillare den Anschlusspunkt beaufschlagt. Das Design der Mikrosensoren und die Reihenfolge der Kalibrierung der verschiedenen Parameter muss diesen Korrelationen somit Rechnung tragen. Zusätzlich zu den vorgestellten Sensoren können natürlich auch andere Sensortypen eingesetzt werden, die sich in einer Halbleitertechnologie herstellen lassen. Explizit erwähnt sind hier Hallelemente, die nicht nur empfindlich auf magnetische Felder sind, sondern die auch als Stresssensoren verwendet werden können. Auch mikromechanische Sensoren sind verwendbar.

**Patentansprüche**

1. Verfahren für die Kalibrierung von wenigstens einem Parameter eines Wire Bonders (3), der eine einen Draht führende Kapillare (11) aufweist, **gekennzeichnet durch die folgenden Schritte**:

   a) Zuführen eines auf einem Substrat (1) montierten Chips (2) zur Bondstelle, wobei der Chip (2) wenigstens einen Sensor (5; 6) mit elektrischen Anschlusspunkten (7) enthält und wobei elektrische Verbindungen zwischen den Anschlusspunkten (7) des Sensors (5; 6) und auf dem Substrat (1) angeordneten Anschlusspunkten (8) entweder bereits hergestellt sind oder vom Wire Bonder (3) hergestellt werden,
   b) Durchführen wenigstens eines Vorganges zur Kalibrierung eines den Bondprozess beeinflussenden Parameters, in dessen Verlauf die Spitze der Kapillare (11) oder die von der Spitze der Kapillare (11) geführte Bondkugel (22) des Drahtes einen weiteren Anschlusspunkt (4) des Chips (2) berührt, wobei die während dieses Kalibriervorganges vom Sensor (5; 6) gelieferten Signale erfasst und ausgewertet werden, und wobei der Parameter verändert wird, bis das vom Sensor (5; 6) gelieferte Signal einen vorbestimmten Wert aufweist.

2. Verfahren nach Anspruch 1, **dadurch gekennzeichnet, dass** als Parameter die Bondkraft ($F_B$) kalibriert wird.

3. Verfahren nach Anspruch 2, **dadurch gekennzeichnet, dass** als Parameter die der Kapillare (11) zugeführte Ultraschallleistung kalibriert wird.

4. Verfahren nach Anspruch 3, **dadurch gekennzeichnet, dass** als Parameter die Zeitdauer ($t_5$-$t_2$) gemessen wird, die vom Anlegen des Ultraschalls an die Kapillare (11) verstreicht bis die Bondkugel (22) auf dem Anschlusspunkt (4) haftet, und dass die Zeitdauer ($t_4$-$t_2$), während der die Kapillare (11) mit Ultraschall beaufschlagt wird, entsprechend dieser Zeitdauer ($t_5$-$t_2$) eingestellt wird.

5. Chip (2) für die Kalibrierung eines Wire Bonders (3) mit einem ersten Anschlusspunkt (4), der als Kalibrierungsstelle dient, und mit einem im Chip (2) integrierten Sensor (5; 6), der unterhalb des ersten Anschlusspunktes (4) oder seitlich versetzt unmittelbar neben dem ersten Anschlusspunkt (4) angeordnet ist.

6. Chip (2) nach Anspruch 5, **dadurch gekennzeichnet, dass** der Sensor (5; 6) druckempfindlich ist.

7. Chip (2) nach Anspruch 6, **dadurch gekennzeichnet, dass** der Sensor (5; 6) ein Widerstandselement ist, das aus einer in das Bulksilizium des Chips (2) diffundierten Bahn (12) oder aus einer Bahn aus Polysilizium (19) besteht.

8. Chip (2) nach Anspruch 5, **dadurch gekennzeichnet, dass** der Sensor (5; 6) temperaturempfindlich ist.

9. Chip (2) nach Anspruch 8, **dadurch gekennzeichnet, dass** der Sensor (5; 6) aus metallischen Leiterbahnen (20) gebildet ist.

10. Chip (2) nach einem der Ansprüche 5 bis 9, **dadurch gekennzeichnet,** dass die Oberfläche des ersten Anschlusspunktes (4) mit einer Passivierungsschicht (17) bedeckt ist.

Fig 1

Fig 2a

Fig 2 b

Fig 3

Fig 4

Fig 5

Fig 6a

Fig 6b

Fig 7

Fig 8

Fig 9

**Europäisches Patentamt**

# EUROPÄISCHER RECHERCHENBERICHT

Nummer der Anmeldung

EP 98 81 0104

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | PATENT ABSTRACTS OF JAPAN vol. 095, no. 006, 31.Juli 1995 & JP 07 074215 A (NEC CORP;OTHERS: 01), 17.März 1995, * Zusammenfassung * | 1,2,5,6 | B23K20/00 |
| A | PATENT ABSTRACTS OF JAPAN vol. 014, no. 222 (E-0926), 10.Mai 1990 & JP 02 054944 A (FUJITSU LTD), 23.Februar 1990, * Zusammenfassung * | 1,5,7 | |

**RECHERCHIERTE SACHGEBIETE (Int.Cl.6)**

B23K
H01L

Der vorliegende Recherchenbericht wurde für alle Patentansprüche erstellt

| Recherchenort | Abschlußdatum der Recherche | Prüfer |
|---|---|---|
| DEN HAAG | 7.Juli 1998 | Aran, D |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)